(19) Europäisches Patentamt
European Patent Office
Office européen des brevets

(11) EP 0 746 016 B1

(12) EUROPÄISCHE PATENTSCHRIFT

(45) Veröffentlichungstag und Bekanntmachung des Hinweises auf die Patenterteilung:
**19.01.2005 Patentblatt 2005/03**

(51) Int Cl.7: **H01L 21/311**, H01L 21/00

(21) Anmeldenummer: **96106261.9**

(22) Anmeldetag: **19.04.1996**

# (54) Verfahren zum selektiven Entfernen von Siliziumdioxid

Process for the active removal of silicum dioxide

Procédé de retrait sélectif de dioxyde de silicium

(84) Benannte Vertragsstaaten:
**DE FR GB IT**

(30) Priorität: **28.04.1995 DE 19515796**

(43) Veröffentlichungstag der Anmeldung:
**04.12.1996 Patentblatt 1996/49**

(73) Patentinhaber: **Infineon Technologies AG**
**81669 München (DE)**

(72) Erfinder:
- **Scheiter, Thomas**
**80469 München (DE)**
- **Näher, Ulrich, Dr.**
**80803 München (DE)**
- **Hierold, Christofer, Dr.**
**81739 München (DE)**

(74) Vertreter: **Kindermann, Peter, Dipl.-Ing.**
**Kindermann Patentanwälte**
**Postfach 1330**
**85627 Grasbrunn (DE)**

(56) Entgegenhaltungen:
**EP-A- 0 601 532**
**EP-A- 0 704 884**
**WO-A-87/01508**
**WO-A-94/27315**
**WO-A-94/28426**
**US-A- 3 920 471**
**US-A- 5 294 568**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 746 016 B1

Printed by Jouve, 75001 PARIS (FR)

## Beschreibung

Die vorliegende Erfindung betrifft ein Verfahren zum selektiven Ätzen von $SiO_2$-Schichten auf Halbleiterchips, insbesondere zum selektiven Entfernen von Opferschichten gegenüber Metallisierungen.

Beim Freiätzen mikromechanischer Strukturen mit einer Opferschicht (Sacrificial Layer) treten als Schwierigkeiten auf, daß nach dem Ätzen die mikromechanische Struktur nach dem Abtrocknen der nassen Ätzflüssigkeit auf der Oberfläche des Chips haftenbleibt und daß das für das Ätzen verwendete Ätzmittel nicht selektiv z. B. gegenüber Aluminium eingesetzt werden kann. Bei naßchemischem Ätzen wird das flüssige Ätzmittel anschließend mit einer ebenfalls flüssigen Chemikalie von der Oberfläche des geätzten Chips entfernt. Diese Chemikalie wird dann entfernt, indem man sie in den gasförmigen Agregatzustand überführt und so die Oberfläche des Chips trocknet, so daß die freigeätzte Struktur nicht auf der Oberfläche des Chips haftenbleibt. Sollen mikromechanische Strukturen z. B. aus einem Metall (z. B. einer Metallisierung aus Aluminium) realisiert werden, dann kann eine Opferschicht aus Siliziumdioxid nicht mit der üblicherweise als Ätzmittel verwendeten Flußsäure (Fluorwasserstoff in wäßriger Lösung) selektiv gegenüber dem Metall entfernt werden, weil auch das Metall von der Flußsäure angegriffen und zersetzt würde. Daher müssen z. B. Metallisierungen aus Aluminium, wie z. B. Anschlußkontakte oder Leiterbahnen, vor dem Ätzen mit Flußsäure mit aufwendigen Maßnahmen gegen den Ätzangriff geschützt werden, was z. B. durch Aufbringen von Lackmasken geschehen kann. Bei der Herstellung von mikromechanischen Strukturen, die nicht aus Silizium bestehen, müssen deshalb andere Materialien als Siliziumdioxid für Opferschichten verwendet werden. Die Verwendung anderer Ätzmittel als Flußsäure ist sehr aufwendig und mit den üblichen Herstellungsprozessen nicht kompatibel. Ein verbesserter Ätzprozeß mit HF wurde 1991 von D. Syverson am Institute of Environmental Sciences als FSI Technical Report 369 vorgestellt.

In der US 5,294,568 ist ein Verfahren zum selektiven Ätzen einer infolge eines natürlichen Oxidationsprozesses auftretenden Siliziumdioxidschicht von einer Oberseite eines Halbleiterbauelementes beschrieben. Die Oxidschicht wird einer Mischung aus HF und Wasser in der Gasphase ausgesetzt, wobei die Ätzdauer und die Bedingungen, insbesondere Temperatur und Partialdrücke, so kontrolliert werden, daß nur das natürlich entstandene Oxid entfernt wird, ohne daß sich in wesentlichem Umfang auf der Oberseite flüssiges Wasser niederschlägt und ohne daß weitere Oxidschichten, die für die Funktion des Bauelementes vorgesehen sind, angegriffen werden.

In der WO 94/27315 ist ein Verfahren zum Ätzen von Oxidschichten beschrieben, bei dem die durch Kondenswasser auf der geätzten Oberfläche hervorgerufene Ungleichmäßigkeit des Ätzabtrages durch Beifügung von Carboxylsäure zum Ätzmittel beseitigt wird.

In der WO 94/28426 ist ein Verfahren zur Herstellung oberflächenmikromechanischer Strukturen beschrieben, bei dem eine Opferschicht aus Siliziumoxid mittels eines Gemisches aus HF und Wasser in einer Dampfphasenätzung entfernt wird. Es ist angegeben, daß neben einer Heizung eine Kondensation eines Wasserfilms auch durch ein Pumpen verhindert werden kann.

In der US 3,920,471 ist ein Verfahren beschrieben, mit dem $SiO_2$ bei Anwesenheit von Metallisierungen aus Aluminium geätzt wird und durch Beigabe von $NH_4F$ zu einem HF-haltigen Ätzmittel eine als Passivierungsschicht geeignete $AlF_3$-Schicht konserviert wird. Aufgabe der vorliegenden Erfindung ist es, ein Verfahren für Halbleitertechnologie anzugeben, mit dem $SiO_2$ selektiv insbesondere gegenüber Metall, wie z. B. Aluminium, ohne großen zusätzlichen Aufwand entfernt werden kann. Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Verfahren erfolgt das Ätzen unter Verwendung von Fluorwasserstoff im gasförmigen Aggregatzustand, also mit Hilfe eines trockenen Ätzprozesses. Um die Ätzung zu ermöglichen, wird das für die chemische Umsetzung erforderliche Wasser ebenfalls im gasförmigen Aggregatzustand, also als Wasserdampf, zugesetzt. Die für die Ätzung des Siliziumdioxids relevante, vereinfachte Reaktionsgleichung lautet:

$$SiO_2 + 4HF + 2H_2O \rightarrow SiF_4 + 4H_2O.$$

Aus dieser Gleichung ist zu entnehmen, daß Wasser erforderlich ist, um die Reaktion in Gang zu setzen, und daß Wasser außerdem ein Endprodukt der chemischen Umsetzung ist. Die Menge an vorhandenem Wasser erhöht sich daher im Verlauf des Ätzvorganges.

Bei dem erfindungsgemäßen Verfahren wird zunächst Wasserdampf in ausreichender Menge zur Verfügung gestellt, damit die Ätzreaktion einsetzen kann. Die Menge an Wasserdampf wird aber so begrenzt, daß keine Kondensation des Wasserdampfes zu flüssigem Wasser erfolgt. Da während des Ätzens weiteres Wasser entsteht, kann nicht verhindert werden, daß im Verlaufe des Ätzvorganges im Inneren eines Rezipienten, in dem die Ätzung erfolgt, eine so hohe Sättigung an Wasserdampf auftritt, daß sich schließlich Wassertropfen auf dem zu bearbeitenden Chip niederschlagen. Daher wird bei dem Verfahren der Ätzvorgang rechtzeitig abgebrochen, indem die in dem Rezipienten vorhandenen Gase durch einen Gasauslaß abgelassen werden und der Rezipient und damit die Oberfläche des zu

ätzenden Chips mit einem Inertgas, wie z. B. Stickstoff, gespült wird.

Dieses Verfahren läßt sich z. B. in der in der beigefügten Figur im Schema gezeichneten Apparatur durchführen. Die zu bearbeitende Probe 1, z. B. ein mit einer mikromechanischen Struktur auf einer $SiO_2$-Schicht versehenes Halbleiterbauelement, wird in den Rezipienten 2 gebracht. Dieser Rezipient besitzt eine Gaseinlaßöffnung 3 und eine Gasauslaßöffnung 4. Die für das Verfahren erforderlichen Gase $H_2O$, HF und z. B. $N_2$ werden über die Gaseinlaßöffnung 3 jeweils in den Rezipienten 2 eingelassen. Für die Dosierung dieser Gase sind regelbare Ventile 5 eingebaut. Diese Ventile 5 können mit einem Massendurchflußmesser verbunden werden, der die Menge des durchströmenden Gases feststellt und ggf. über eine elektronische Regelvorrichtung automatisch, z. B. programmgesteuert, die Ventile öffnet oder schließt. Der Wasserdampf kann z. B. aus einem Verdampfer kommen; HF und $N_2$ werden z. B. aus angeschlossenen Gasflaschen eingeleitet. Statt der gezeigten Vorrichtung können z. B. Anordnungen mit drei separaten Gaseinlaßöffnungen für die verwendeten Gase verwendet werden.

Das Abtragen der $SiO_2$-Schicht von der zu bearbeitenden Probe erfolgt erfindungsgemäß durch mehrfach wiederholte kurze Ätzvorgänge. Zunächst werden Wasserdampf und gasförmiger Fluorwasserstoff in der für das Ätzen erforderlichen Relation in den Rezipienten 2 eingelassen. Dabei werden allerdings die Menge des Wasserdampfes und die Reaktionsgeschwindigkeit so begrenzt, daß keine Kondensation auftritt. Es erfolgt dann der Ätzangriff auf das $SiO_2$. Im Verlauf des Ätzvorganges entsteht entsprechend der obenstehenden Reaktionsgleichung weiterer Wasserdampf. Die Ätzung muß mit einer minimalen Ätzrate (Geschwindigkeit des Ätzprozesses) erfolgen, weil der Prozeß sonst instabil wird. Eine maximale Ätzrate ist durch die physikalischen Bedingungen gegeben. Innerhalb des für die Ätzrate möglichen Bereiches darf die Ätzdauer nicht zu groß gewählt werden, damit sich keine Wassertropfen auf der geätzten Oberfläche niederschlagen. Bevor eine kritische Konzentration des Wasserdampfes, d. h. Sättigung des in dem Rezipienten befindlichen Gases mit Wasserdampf, bei der dann eine Kondensation des Wassers stattfinden würde, erreicht ist, wird der Ätzvorgang abgebrochen und die in dem Rezipienten 2 vorhandenen Gase durch die Gasauslaßöffnung 4 abgelassen. Das geschieht, indem ein Inertgas, wie z. B. Stickstoff, durch die Gaseinlaßöffnung 3 in den Rezipienten eingelassen wird und auf diese Weise die übrigen Gase aus dem Rezipienten 2 verdrängt werden. Nachdem der gesamte Wasserdampf aus dem Rezipienten entfernt wurde oder die Konzentration des Wasserdampfes indem in dem Rezipienten befindlichen Gas zumindest ausreichend gesenkt wurde, wird durch Einlassen von HF und ggf. Wasserdampf durch die Gaseinlaßöffnung 3 in den Rezipienten ein neuer Ätzvorgang begonnen. Durch Wiederholung dieser einzelnen Abschnitte des Ätzprozesses läßt sich die Ätzung in dem vorgesehenen Ausmaß durchführen. Es läßt sich daher auch eine Unterätzung von Strukturen erreichen, die mehrere Mikrometer unter diese Strukturen reicht, ohne daß befürchtet werden muß, daß sich eine Flüssigkeit auf der geätzten Oberfläche niederschlägt und anschließend das Problem des Haftens auftritt.

Im folgenden werden eine genauere Beschreibung des Verfahrens und zweckmäßige Ausführungsformen dafür angegeben. Als Rezipient wird eine zylinderförmige Ätzkammer verwendet, in der die zu bearbeitende Scheibe mit ihrer Oberfläche nach oben auf drei Spitzen gelagert wird. Mit Hilfe von drei mass flow controllers (MFC's) kann ein kontrollierter Zufluß der verwendeten Gase eingestellt werden. Die verwendeten MFC's sind z. B. für die folgenden maximalen Durchflußraten vorgesehen:

| | |
|---|---|
| MFC 1 ($N_2$ als Trägergas) | 30,0 l/min |
| MFC 2 ($N_2$ mit $H_2O$ angereichert) | 2,0 l/min |
| MFC 3 (HF-Gas) | 0,5 l/min |

Der Anreicherungsgrad des Stickstoffs mit Wasser (MFC 2) beträgt ca. 1 %.

Das Volumen wird ständig mit Stickstoff gespült, der u.a. dazu dient, den Fluorwasserstoff zu verdünnen und die Reaktionsprodukte (Wasser und $SiF_4$) abzuführen. Zur Ätzung wird der Stickstoff mit HF-Gas gemischt. Die maximale HF-Konzentration liegt etwa bei 1,6% der Stickstoffmenge. Zusätzlich zum HF-Gas kann in die Kammer Wasserdampf eingeleitet werden (z. B. maximal 0,3 $cm^3/s$, damit im Mittel eine absolute Luftfeuchtigkeit von ca. 0,001 Vol.-%).

In dem Rezipienten herrscht z. B. ein Druck von ca. 1 bar bei einer Temperatur von z. B. 24°C. Da der Druck konstant gehalten wird, entspricht die abfließende Gasmenge der insgesamt eingelassenen Gasmenge, die weitgehend durch die Stickstoffmenge gegeben ist.

Um die Wasser- und die HF-Konzentration als Funktion der Zeit anzugeben, nimmt man an, daß keine Ätzung stattfindet und daß die einfließende Menge des jeweiligen Gases vorgegeben ist und die ausfließende Gasmenge durch die momentane Konzentration dieses Gases in dem Rezipienten und die gesamte Austauschrate gegeben ist. Für die HF-Konzentration gilt z.B.:

$$\frac{dn}{dt} = \frac{N_L}{V_K}\Phi_{HF} - \frac{n}{V_K}\cdot\Phi_{ges}$$

mit
$[n]=1/m^3$ (Anzahl pro Volumen),
$[\Phi]=m^3/s$ (Teilchenfluß),
$V_m=22.4\ m^3/kmol$ (Molvolumen),
$N_A=6.022\cdot 10^{26}/kmol$ (Avogadro-Konstante),
$N_L=N_A/V_m=2.688\ 10^{25}/m^3$,
$V_K=3{,}4\cdot 10^{-4}\ m^3$ (Volumen des Rezipienten),
$N=N_L V_K$ (Gesamtzahl der Gasatome/-moleküle).

Die Lösung der Differentialgleichung ist

$$n(t) = N_L\cdot\Phi_{HF}/\Phi_{ges}\cdot(1-\exp(-\Phi_{ges}\cdot t/V_K)).$$

Daher stellt sich nach der Zeit von ca. $2\cdot V_K/\Phi_{ges}$ ein Gleichgewicht der Konzentration ein, wobei diese Zeit unabhängig von der eingelassenen HF-Menge ist. Die Wasserkonzentration ist genauso schnell im Gleichgewicht wie die HF-Konzentration. Bei maximalem Spülfluß des Trägergases kann man davon ausgehen, daß sich ohne Ätzung nach der Zeit von ca. 1,5 s die Gasmischung im Rezipienten stabilisiert hat.

Die Zuführung der Gase sowie die Steuerung der mass flow controller ist mit Hilfe eines Computers, der als Steuerrechner verwendet wird, möglich. Hierbei läßt sich der Ätzprozeß in einzelne Abschnitte, wie z.B. Spülungen und Ätzungen, unterteilen. Die in diesem Ausführungsbeispiel verwendete Prozeßsequenz hat die Form

1. Initialisierung (Zugabe von $N_2$, Spülung zur Verdrängung der Luft im Rezipienten),
2. Stabilisierung (Zugabe von $N_2$, ohne Ätzgas, aber mit der bei der Ätzung vorgesehenen Durchflußrate),
3. Vorbehandlung (Zugabe von $N_2$ und $H_2O$, Möglichkeit der Zufuhr von Feuchtigkeit zur Absättigung der Scheibenoberfläche mit H20),
4. Ätzung (Zugabe von $N_2$ und HF bei Vorhandensein von $H_2O$, eigentliche Ätzung),
5. Abschluß (Zugabe von $N_2$, Zufuhr von $N_2$ ohne HF zum definierten Beendigen der Ätzung) und
6. Spülen (Zugabe von $N_2$, abschließender Spülschritt).

Typische Werte für Dauern und Gasflüsse sind dabei z. B.:

| | Schritt | Dauer (s) | $N_2$ (% MFC) | Vap (% MFC) | HF (% MFC) |
|---|---|---|---|---|---|
| 1 | Initialisierung | 5 | 90 | 0 | 0 |
| 2 | Stabilisierung | 5 | 25 | 0 | 0 |
| 3 | Vorbehandlung | 10 | 25 | 50 | 0 |
| 4 | Ätzung | 12 | 25 | 0 | 70 |
| 5 | Abschluß | 5 | 40 | 0 | 0 |
| 6 | Spülen | 5 | 90 | 0 | 0 |

Einzelne Schritte können nach Bedarf wiederholt werden.

Um einen genaueren Einblick in die ablaufenden Reaktionen zu erhalten, ist es notwendig, den chemischen Vorgang in einzelne Teilreaktionen aufzuteilen. Dies ist mit Hilfe der Gleichungen

$$SiO_2 + 4HF \xrightarrow{k1} SiF_4 + 2H_2O$$

$$SiO_2 + 2H_2O \xrightarrow{k2} Si(OH)_4$$

$$Si(OH)_4 + 4HF \xrightarrow{k3} SiF_4 + 2H_2O$$

möglich. Ist bei der Ätzung kein Wasser vorhanden, so läuft die Reaktion im wesentlichen nach der ersten Gleichung ab, d.h. geschwindigkeitsbestimmend ist der Reaktionskoeffizient $k_1$. Bei Zugabe von Wasserdampf vor der eigentlichen Ätzung bzw. bei genügend schneller Ätzung (d. h. Wasser als Reaktionsprodukt in ausreichender Menge vorhanden), läuft die Reaktion katalytisch entsprechend der zweiten und der dritten Gleichung ab. Geschwindigkeitsbestimmend sind nun die Koeffizienten $k_2$ und $k_3$, wobei gilt $k_2$, $k_3 >> k_1$. Die Ätzung einer Opferschicht allein durch die in der ersten Gleichung gegebene Reaktion bei dementsprechend sehr niedrigen Ätzraten ist wegen der großen notwendigen Unterätzungen nicht möglich.

Die Ätzreaktion setzt nicht sofort nach dem Einleiten von HF-Gas in den Rezipienten ein. Nach etwa 1,5 s ist eine konstante HF-Konzentration im Rezipienten erreicht. Zu Beginn der Ätzung ist nicht ausreichend Wasser als Katalysator der Ätzreaktion an der Ätzoberfläche vorhanden, und das Einsetzen der Reaktion ist deshalb durch die Reaktionskonstante $k_1$ zusätzlich verzögert. Ist die Ätzreaktion in Gang gekommen, so entsteht durch die Reaktion ausreichend Wasser zur Katalyse der Reaktion, die Ätzung wird beschleunigt, und eine konstante Ätzrate stellt sich ein. Eine Vorbehandlung mit einem Gemisch aus Stickstoff und Wasserdampf ermöglicht es, daß bei Beginn der Ätzung mit HF-Gas bereits der zum Start der Ätzung notwendige Gehalt an Wasserdampf vorhanden ist. Die Vorbehandlung sollte mit möglichst maximaler Zufuhr an Wasserdampf erfolgen. Der Trägergasfluß sollte dabei gleich dem Gasfluß während des Ätzschrittes sein.

Auch während der Ätzung ist es möglich, mit Wasser angereicherten Stickstoff zuzuführen. Die zuführbare Wassermenge ist jedoch wesentlich geringer, als die an der geätzten Oberfläche durch die Reaktion entstehende Wassermenge. Die Ätzrate ist nach ausreichender Vorbehandlung weitgehend unabhängig von der während der Ätzung zusätzlich zugeführten Wassermenge. Entscheidend für den Ablauf der Ätzung ist die Konzentration des Ätzgases während der Ätzung. Zur Bestimmung dieses Einflusses wurden mehrere Ätzungen mit identischen Vorbehandlungen durchgeführt. Die Konzentration des Trägergases während der Ätzung wurde zunächst konstant gehalten und die zugeführte Menge an HF variiert. Eine Erhöhung der Konzentration des Reaktionsgases reduziert die Zeit bis zum Beginn der Ätzung und bewirkt eine Erhöhung der Ätzrate. Die Konzentration des Ätzgases im Rezipienten wird jedoch nicht nur vom HF-Zufluß bestimmt, sondern auch von der zufließenden Trägergasmenge. Die Ätzrate hängt vom Verhältnis der Gasmengen von HF und $N_2$ ab. Die Zeit bis zum Beginn der Ätzung nimmt mit zunehmendem Trägergasfluß und abnehmendem Ätzgasfluß zu. Es wurde beobachtet, daß die Ätzung unterhalb einer bestimmten Mindestätzrate instabil, d.h. nicht reproduzierbar ist.

Im Folgenden wird mit Hilfe eines Diffusionsmodells beschrieben, unter welchen Bedingungen sich Wassertropfen auf der geätzten Oberfläche bilden. Daraus kann theoretisch ein Bereich für die maßgeblichen Prozeßparameter errechnet werden, in dem geätzt werden kann, ohne daß Wassertropfen auf der geätzten Oberfläche kondensieren und somit ohne daß Sticking auftritt.

Erfindungsgemäß wird die Flußrate des zugegebenen HF-Gases und damit die Reaktionsgeschwindigkeit gesteuert. Da Wasser bei der Reaktion entsteht, ist zusätzliche Wasserzufuhr nur bis zum Einsetzen der Reaktion notwendig. Die bei der Reaktion an der geätzten Oberfläche pro Zeiteinheit entstehende Wassermenge ist proportional zur Ätzrate. Bei der Einstellung der Prozeßparameter muß darauf geachtet werden, daß die Ätzrate einen bestimmten Grenzwert nicht überschreitet, damit keine Tröpfchenbildung auftritt. Eine Schicht von Siliziumoxid einer Dicke von etwa 1 µm wird durch HF in eine etwa 2 µm dicke Wasserschicht umgesetzt.

Mit Hilfe eines Diffusionsmodells kann der Partialdruck des Wasserdampfes als Funktion der Ätzrate beschrieben werden, wobei man vereinfachend annehmen kann, daß die Diffusion der wesentliche Mechanismus für den Abtransport des bei der Reaktion entstehenden Wassers von der Ätzfläche darstellt.

Nach dem Ersten Fickschen Gesetz ist der Stofftransport mit dem Konzentrationsgradienten verknüpft:

$$j=-D \text{ grad } n.$$

Dabei ist j die Teilchenstromdichte, n die Teilchendichte und D die Diffusionskonstante. D. h., wenn das durch die Reaktion entstehende Wasser sofort als Wasserdampf entweicht, muß sich direkt an der Oberfläche ein Gradient der Teilchendichte einstellen, der der Flußdichte des Wasserdampfes entspricht. Falls man aus Gründen der Symmetrie annimmt, daß der Gradient der Teilchendichte senkrecht auf der zu ätzenden Oberfläche steht (z-Richtung), erhält man aus dem Zweiten Fickschen Gesetz

$$dn/dt=D\, d^2n/(dz)^2.$$

Es wird angenommen, daß das entstehende Wasser sich im gesamten Raum oberhalb der geätzten Oberfläche durch Diffusion verteilt. Messungen zeigen, daß die Ätzrate während des Ätzvorgangs als konstant und daher der Teilchenfluß an der geätzten Oberfläche ebenfalls als konstant angenommen werden kann. Unter dieser Voraussetzung erhält man die Konzentrationsverteilung an der geätzten Oberfläche als

$$n(t)=2j\, (t/(\pi D))^{1/2}.$$

Die kritische Ätzrate, die bei der Ätzung nicht überschritten werden darf, da sonst Tropfenbildung auftritt, ist erreicht, sobald die dem Dampfdruck im Rezipienten entsprechende Wasserkonzentration an der geätzten Oberfläche überschritten ist. Für jede beliebige Ätzrate R läßt sich diese kritische Ätzzeit $t_{krit}$ entsprechend den obenstehenden physikalischen Überlegungen abschätzen zu:

$$t_{krit}=\pi D p_{vap}^2/(4n^2R^2k^2T^2)$$

mit
$D \approx 0{,}24\ cm^2/s$ (Diffusionskonstante von Wasser in Luft),
$p_{vap}$=Dampfdruck von Wasser,
R=Ätzrate (in nm/s),
$n=2{,}3 \cdot 10^{22}\ cm^{-3}$ (Teilchendichte von thermischem Siliziumdioxid),
$k=1{,}38 \cdot 10^{-23}$ J/K (Boltzmannkonstante) und
T=Temperatur in K.
Die maximale Ätzdauer nimmt also umgekehrt proportional zum Quadrat der Ätzrate ab.

In größerer Entfernung von der geätzten Oberfläche tragen zusätzlich zur Diffusion auch auftretende Strömungen zum Abtransport von Teilchen bei. Bei konstantem Zufluß des Trägergases $N_2$ und des Reaktionsgases HF entsteht ein Teilchenstrom oberhalb der geätzten Oberfläche. Der Abtransport des entstehenden Wassers ist zeitlich im wesentlichen begrenzt durch die Austauschzeit $t_1$ der Gasmenge im Rezipienten und durch die Zeit $t_2$, die für die Verteilung des freiwerdenden Wasserdampfes durch Diffusion notwendig ist. Messungen zeigen, daß $t_1 < t_2$ gilt.

Moleküle werden durch Strömung (Konvektion) oder durch Diffusion transportiert. Zu Oberflächen hin wird die Strömung immer langsamer, und dort bildet sich eine Grenzschicht aus, in der keine Konvektion stattfindet und die Strömungsgeschwindigkeit klein ist (laminare Strömung). In dieser Grenzschicht sorgt Diffusion für den Stofftransport. Moleküle, die von der Oberfläche verdampfen, müssen erst durch die Grenzschicht diffundieren, bevor sie von der Strömung mitgenommen werden. Man kann daher annehmen, daß eine oberflächennahe Schicht existiert, in der Stofftransport ausschließlich durch Diffusion stattfindet, und darüber ein Strömungsbereich existiert, in dem die Moleküle relativ schnell wegtransportiert werden (mit der Zeitskala $t_1$).

Vereinfachend werden zwei Grenzschichtdicken angenommen: zum einen die Schichtdicke $\delta_s$, innerhalb der sich die Strömungsgeschwindigkeit der Gase von 0 m/s an der Oberfläche auf den Wert $v_o$ ändert, und zum zweiten die Schichtdicke $\delta_c$, innerhalb der die Wasserkonzentration vom Wert $n_s$ an der geätzten Oberfläche auf einen (vernachlässigbar kleinen) Wert $n_o$ abgenommen hat. Als Modell wird eine parallel zur Oberfläche angeströmte Platte angenommen. Die Dicke der Grenzschicht der laminaren Strömung kann aus allgemeinen Beziehungen zwischen der Viskosität, der Strömungsgeschwindigkeit und den räumlichen Dimensionen abgeleitet werden. Für die Dicke einer laminaren Grenzschicht gilt näherungsweise

$$\delta_s = 5 \cdot (x\eta/v_o)^{1/2}.$$

Dabei ist $\eta$ die kinematische Viskosität des Gases, $v_o$ dessen Geschwindigkeit im Strömungsbereich und x die räumliche Abmessung in der Ebene der Platte. In vorliegendem Modell ergibt sich für die Strömungsgeschwindigkeit aus der Austauschrate näherungsweise der Wert $v_o$=0,1 m/s. Die kinematische Viskosität von Stickstoff ist $\eta$=1,32·10-5 $m^2$/s. Mit x=4 cm als Beispiel erhält man näherungsweise für die Schichtdicke $\delta_s$ =1,2 cm.

Die Geschwindigkeit in der Ebene der Platte in x-Richtung als Funktion der z-Koordinate senkrecht zu dieser Ebene erhält man als $v_x(z)=v_o(1{,}5\ z\ /\ \delta_s - 0{,}5\ z^3\ /\ \delta_s{}^3)$, also richtig $v_x(0)=0$. Mit $t_2 > t_1$ entspricht dies im Modell der Annahme, daß die Strömung den entstehenden Wasserdampf so schnell abtransportiert, daß außerhalb einer Diffusionsschicht die Konzentration des Wasserdampfes schnell abfällt. Die Dicke dieser Diffusionsschicht ist nicht identisch mit der Dicke der laminaren Grenzschicht. Es ist noch erforderlich, den Diffusionsfluß in einer Schicht der Dicke $\delta_c$ über einer Oberfläche zu beschreiben. Auf dieser Oberfläche wird laufend Wasserdampf produziert, welcher durch Diffusion durch die Grenzschicht transportiert wird. Als Randbedingung wurde vorausgesetzt, daß die Konzentration des Wasserdampfes an der Oberseite der Schicht auf Null abgefallen ist.

Im Gleichgewichtsfall (dn/dt = 0) nimmt die Konzentration linear mit dem Abstand zur Oberfläche ab. Außerdem gelten die Randbedingungen $n(z)=n_o$ für $z \geq \delta_c$ und $n(z)=n_s$ für z=0. Das ergibt

$$n(z) = n_0 + (\delta_c - z)\cdot\nabla n = n_0 + \frac{(\delta_c - z)}{\delta_c}\cdot(n_s - n_0).$$

Für den Fluß j von der Oberfläche gilt

$$j = -D\ grad\ n = D\frac{n_s - n_0}{\delta_c}.$$

Damit erhält man einen direkten Zusammenhang zwischen der Wasserdampfkonzentration an der Oberfläche und der Ätzrate. Eine Ätzrate von z.B. 1 nm/s ergibt bei einer Dicke der Diffusionsschicht von 1,2 cm eine Wasserdampfkonzentration an der Oberfläche von $2{,}3\cdot10^{16}$ Moleküle/$cm^3$. Diese Konzentration nimmt linear mit der Ätzrate zu. Bei einer Ätzrate von z. B. 1 nm/s entspricht sie dem Druck im Rezipienten. Bei Ätzraten von mehr als ca. 5 nm/s wird dieser Druck unwichtig verglichen mit der durch die Reaktion produzierten Wassermenge. Im Vergleich dazu beträgt die maximale mögliche Wasserdampfkonzentration (Dampfdruck) bei 20°C $6{,}7\cdot10^{17}$ Moleküle/$cm^3$. Nach obigem Modell erwartet man also bei vollem Spülfluß im Gleichgewicht (lange Ätzzeit bei konstanter Ätzrate) bei Ätzraten oberhalb einer kritischen Ätzrate (z. B. bei einer Ätzrate von 30 nm/s) Tröpfchenbildung. Die kritische Ätzrate hängt auch von der Strömungsmenge des Spülgases im Rezipienten ab. Senkt man den Spülfluß, so nimmt die Grenzschichtdicke zu. Das erhöht die Konzentration des Wasserdampfs an der geätzten Oberfläche, und Tröpfchenbildung tritt früher auf. Es ist nicht möglich, den Gasfluß ohne Änderung der Ätzrate zu verändern. Möchte man die Ätzrate beibehalten, muß man gleichzeitig auch die zugeführte HF-Menge erhöhen. Doch selbst dann nimmt die Wasserkonzentration nach obigem Modell ab.

Grundlage für die hier vorgenommene Abschätzung ist die Separation von Diffusion und Strömung aufgrund der Beziehung $t_2 > t_1$. Man kann $t_2$ aus dem Ersten Fickschen Gesetz berechnen. Man erhält für die Diffusion eine maßgebliche Zeiteinheit von ca. 3 s. $t_2$ ist daher etwa doppelt so groß wie $t_1$.

Für große Zeiten geht die Reaktion ins Gleichgewicht, die endliche Dicke der Grenzschicht muß jetzt berücksichtigt werden. Wie im Gleichgewichtsfall kann man die kritische Ätzrate, bei der die Wasserdampfkonzentration über dem Dampfdruck liegt, bestimmen. Diese Ätzrate ist jetzt zeitabhängig. Während kurzer Zeit kann man beliebig schnell ätzen, ohne daß sich Tröpfchen bilden. Die Grenzschicht muß erst mit Wasser aufgefüllt werden. Nach einer Sekunde erhält man z.B. bei maximalem Spülfluß eine kritische Ätzrate von 60 nm/s. Nach drei Sekunden ist die kritische Ätzrate 35 nm/s.

Durch die eingelassene HF-Menge (als Beispiel $2{,}1\cdot10^{20}$ Moleküle pro Sekunde) wird die maximale Ätzrate vorgegeben. Wenn alle Moleküle reagieren, entspricht dies einer maximalen Ätzrate von 130 nm/s. Für den maximalen Fluß des HF-Gases durch die Grenzschicht auf die Oberfläche gilt

$$j=D\ n(\delta_c)/\delta_c.$$

Wegen etwa gleich großer Molekülmassen ist die Diffusionskonstante von HF etwa gleich der von Wasser. Mit einer HF-Konzentration von $4{,}3\cdot10^{17}$ Moleküle/$cm^3$ ergibt sich ein Fluß auf die Oberfläche von $j=9\cdot10^{16}$ $cm^2$/s. Das entspricht einer maximalen Ätzrate von 10 nm/s. Wenn der Spülfluß nachläßt, erhöht sich dieser Wert.

Tropfenfreie Ätzung kann im Prinzip auf zwei Arten erreicht werden. Zum einen kann mit einer mittleren Ätzrate

geätzt werden, wobei der Ätzvorgang vor Erreichen der kritischen Ätzzeit $t_{krit}$ abgebrochen werden muß. Die an der geätzten Oberfläche entstandene Wassermenge muß durch eine Spülung mit Stickstoff abtransportiert werden. Die für diesen Vorgang notwendige Spülzeit läßt sich mit Hilfe des Diffusionsmodells berechnen. Da von der geätzten Schicht pro Ätzschritt innerhalb der kritischen Ätzzeit höchstens etwa 100 nm abgetragen werden, muß die Ätzung als mehrfach unterbrochene Ätzung, im Beispiel mit ca. 20 aufeinanderfolgenden Ätzschritten, durchgeführt werden. Eine zweite Möglichkeit besteht darin, die Ätzung im stationären Bereich, also bei niedrigen Ätzraten, dafür jedoch mit beliebig langer Ätzdauer durchzuführen. Wegen der Instabilität der Ätzung bei geringer Zufuhr von HF kann eine Mindestätzrate dabei nicht unterschritten werden. Aufgrund der räumlichen Inhomogenität der Ätzung ergibt sich nicht notwendig ein scharfer Übergang zwischen einem Ätzbereich, in dem Sticking auftritt, und einem Ätzbereich, in dem kein Sticking auftritt.

Im Gegensatz zu herkömmlichen Trockenätzungen im Plasma ist das erfindungsgemäße Verfahren vollständig isotrop und daher besonders für Anwendungen in der Oberflächenmikromechanik geeignet. Es lassen sich damit also besonders gut Sensoren oder Aktuatoren herstellen, bei denen ein bewegliches Teil z. B. aus einem Metall, wie z. B. insbesondere Aluminium, aus Polysilizium über einer Oberfläche aus Halbleitermaterial hergestellt werden muß.

Aluminium z. B. wird von Fluorwasserstoff in wäßriger Lösung infolge des Zusammenwirkens von Korrosion und Ätzung zersetzt. Bei Fluorwasserstoff im gasförmigen Aggregatzustand, wie er bei dem erfindungsgemäßen Verfahren verwendet wird, tritt keine Korrosion des Aluminiums auf, so daß vorhandene Strukturen aus Aluminium nicht beschädigt oder zersetzt werden. Es wird also nicht nur das Haften beweglicher Teile auf der Oberfläche nach dem Abtrocknen einer Flüssigkeit verhindert, sondern eine hohe Selektivität der Ätzung des $SiO_2$ gegenüber der Metallisierung erreicht. Dieses Verfahren ist daher bei allen Herstellungsverfahren von Halbleiterchips vorteilhaft anwendbar, bei denen Metallisierungen aufgebracht werden und daran anschließend $SiO_2$ geätzt werden muß, ohne daß diese Metallisierungen beschädigt werden. Das ist bei herkömmlichen, naßchemischen Ätzverfahren aufgrund der ungenügenden Selektivität nicht möglich.

Bei dem erfindungsgemäßen Verfahren werden die verwendeten Gase über die Ventile 5 separat dosiert. Es ist daher möglich, das Verfahren an die verschiedensten Betriebsbedingungen anzupassen, wie z. B. Volumen des verwendeten Rezipienten, Ausdehnung der $SiO_2$-Schichten, an denen die Ätzung angreift, Ätzdauer und dergleichen. Nachdem die Zahl und Dauer der einzelnen Ätzvorgänge ermittelt wurde, kann das Verfahren durch eine elektronische Regelung der Ventile weitgehend automatisiert werden.

## Patentansprüche

**1.** Verfahren zum selektiven Entfernen von $SiO_2$ gegenüber Halbleitermaterialien und/oder Metall, bei dem

a) ein zu bearbeitendes, mit einer $SiO_2$-Schicht versehenes Halbleiterbauelement (1) in einen Rezipienten (2) mit mindestens einer Gaseinlaßöffnung (3) und einer Gasauslaßöffnung (4) gebracht wird,
b) unter Verwendung regelbarer Ventile (5) dosierte Mengen von Fluorwasserstoffgas und Wasserdampf in diesen Rezipienten (2) eingeleitet werden, so daß diese Gase in einer für eine Ätzung ausreichenden Menge zu dem $SiO_2$ in diesem Halbleiter bauelement gelangen, aber die Mengen dieser Gase so begrenzt werden, daß eine Kondensation des Wasserdampfes zu flüssigem Wasser auf dem Halbleiterbauelement (1) während eines Ätzvorganges vermieden wird,
c) ein Ätzvorgang zum Abtragen der $SiO_2$-Schicht ausgeführt und vor dem Stattfinden von Kondensation abgebrochen wird,
d) Wasserdampf, der beim Ätzen als Reaktionsprodukt entsteht, vor dem Auftreten von Kondensation durch die Gasauslaßöffnung entfernt wird und gleichzeitig durch die Gaseinlaßöffnung ein Inertgas in den Rezipienten eingelassen wird und
e) die Schritte b) bis d) nach Bedarf wiederholt werden, wobei die Ätzung mehrfach unterbrochen wird.

**2.** Verfahren nach Anspruch 1,
bei dem in Schritt d) als Inertgas Stickstoff verwendet wird.

**3.** Verfahren nach Anspruch 1 oder 2,
bei dem in Schritt b) regelbare Ventile (5) verwendet werden, die mit Massenflußmessern versehen sind, und die diese Ventile durchströmenden Gasmengen elektronisch geregelt werden.

**4.** Verwendung des Verfahrens nach einem der Ansprüche 1 bis 3 zum Freiätzen beweglicher mikromechanischer Funktionselemente aus Polysilizium oder Aluminium.

## Claims

1. Process for the selective removal of $SiO_2$ with respect to semiconductor materials and/or metal, in which

   a) a semiconductor component (1) which is to be processed and is provided with an $SiO_2$ layer is introduced into a receptacle (2) with at least one gas inlet opening (3) and a gas outlet opening (4),
   b) metered quantities of hydrogen fluoride gas and water vapour are introduced into this receptacle (2) using controllable valves (5), so that these gases reach the $SiO_2$ in this semiconductor component in a quantity which is sufficient for etching to be effected, but the quantities of these gases are also restricted such that condensation of the water vapour to form liquid water on the semiconductor component (1) is avoided during the etching operation,
   c) an etching operation for removal of the $SiO_2$ layer is carried out and is interrupted before condensation occurs,
   d) water vapour which is formed as reaction product during the etching is removed through the gas outlet opening before condensation occurs, and at the same time an inert gas is admitted to the receptacle through the gas inlet opening, and
   e) steps b) to d) are repeated as required, with the etching being interrupted a number of times.

2. Process according to Claim 1, in which nitrogen is used as inert gas in step d).

3. Process according to Claim 1 or 2, in which controllable valves (5) which are provided with mass flowmetres are used in step b), and the quantities of gas flowing through these valves are electronically controlled.

4. Use of the process according to one of Claims 1 to 3 for etching clear moveable micromechanical functional elements made from polysilicon of aluminium.

## Revendications

1. Procédé d'élimination de $SiO_2$ sélectivement par rapport à des matériaux semi-conducteurs et/ou du métal, dans lequel

   a) on met un composant (1) à semi-conducteur à traiter muni d'une couche de $SiO_2$ dans un récipient (2) ayant au moins une ouverture (3) d'entrée pour du gaz et une ouverture (4) de sortie pour du gaz,
   b) en utilisant des vannes (5) réglables on introduit dans ce récipient (2) des quantités dosées de fluorure d'hydrogène gazeux et de vapeur d'eau, de sorte que ces gaz arrivent en une quantité suffisante pour une attaque au $SiO_2$ de ce composant à semi-conducteur, mais les quantités de ces gaz sont limitées de manière à empêcher une condensation de la vapeur d'eau en eau liquide sur le composant (1) à semi-conducteur pendant une opération d'attaque,
   c) on effectue une opération d'attaque pour enlever la couche de $SiO_2$ et on l'interrompt avant que se produise une condensation,
   d) on enlève, par l'ouverture de sortie pour du gaz, avant l'apparition d'une condensation, de la vapeur d'eau qui se produit lors de l'attaque en tant que produit de réaction et on introduit en même temps, par l'ouverture d'entrée pour du gaz, un gaz inerte dans le récipient et
   e) on répète les stades b) à d) suivant les besoins, l'attaque étant interrompue plusieurs fois.

2. Procédé suivant la revendication 1,
   dans lequel on utilise au stade d) de l'azote comme gaz inerte.

3. Procédé suivant la revendication 1 ou 2,
   dans lequel on utilise au stade b) des vannes (5) réglables qui sont munies de mesure de débit massique et on règle électroniquement les quantités de gaz passant dans ces vannes.

4. Utilisation du procédé suivant l'une des revendications 1 à 3, pour rendre libres par attaque des éléments fonctionnels mobiles micromécaniques en polysilicium ou en aluminium.

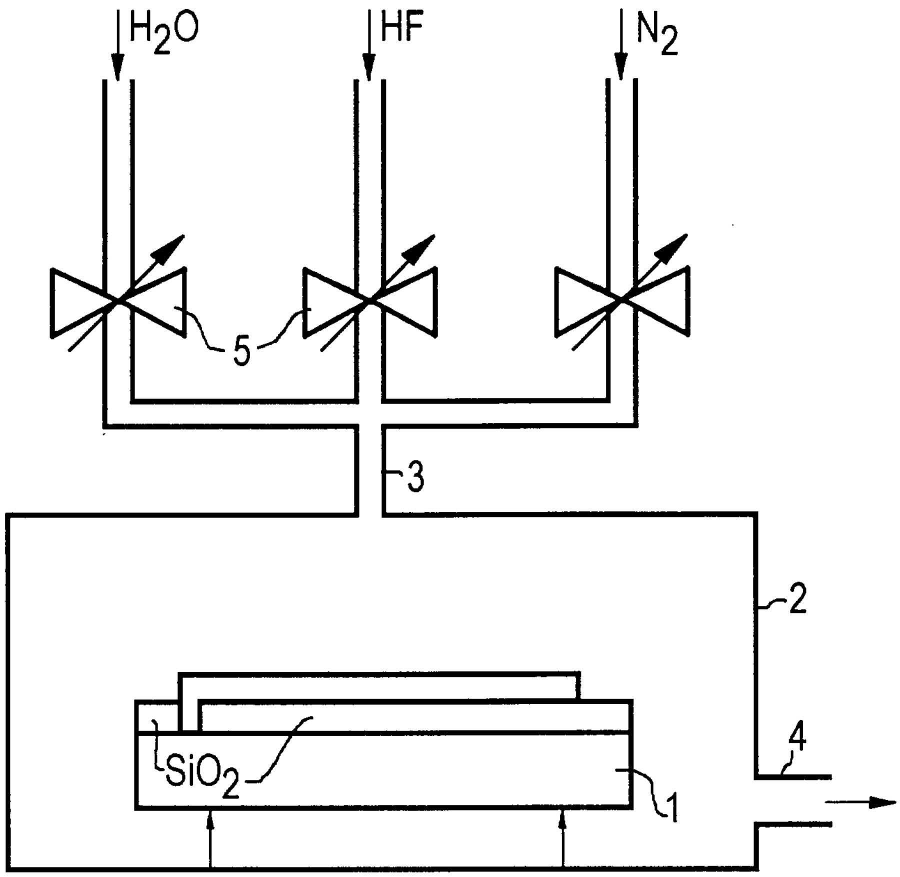
H2O
HF
N2
5
3
2
4
SiO2
1